(19) Europäisches Patentamt
European Patent Office
Office européen des brevets

(11) **EP 2 493 168 A2**

(12) **EUROPEAN PATENT APPLICATION**
published in accordance with Art. 153(4) EPC

(43) Date of publication:
**29.08.2012 Bulletin 2012/35**

(51) Int Cl.:
*H04M 11/06* (2006.01)        *H03H 11/06* (2006.01)
*H03H 11/52* (2006.01)

(21) Application number: **10824497.1**

(22) Date of filing: **20.10.2010**

(86) International application number:
**PCT/ES2010/000431**

(87) International publication number:
**WO 2011/048243 (28.04.2011 Gazette 2011/17)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.10.2009 ES 200930869**

(71) Applicant: **Telefónica, S.A.**
**28013 Madrid (ES)**

(72) Inventors:
• **SANCHEZ YANGÜLA, Manuel**
  **E-28013 Madrid (ES)**
• **YAGÜE VALENTIN, Pablo Alberto**
  **E-28013 Madrid (ES)**

(74) Representative: **Gonzalez-Alberto Rodriguez,
Natalia
GARRIGUES IP, S.L.P.
Hermosilla, 3
28001 Madrid (ES)**

(54) **ACTIVE MICROFILTER FOR VDSL2 COMMUNICATION STANDARD**

(57)    The active microfilter is essentially composed of an active part, which comprises a sign inverter circuit composed of an operational amplifier (13), two resistances and the impedance to be adapted (12), and a passive part which comprises capacitors, coils and resistances.

The active microfilter is arranged in an auto-installable device which comprises a circuit for supplying the active part; wherein the aim is to eliminate the reflections caused by line sections, without adaptation, which interfere with the correct operation of the network when accessing broadband with the VDSL2 standard

FIG. 1

EP 2 493 168 A2

Printed by Jouve, 75001 PARIS (FR)

**Description**

The object of the present invention is to provide an active microfilter for accessing broadband with the VDSL2 standard suppressing or mitigating the effect created by the lack of adaptation of the impedances introduced through cables or couples used in POTN for transmitting information, voice, etc., within a user's local equipment.

The invention is applicable to the field of telecommunications, preferably in broadband applications through the plain old telephone network or POTN, providing an active microfilter essentially made up of an active part comprising a sign inverter circuit and a passive part comprising capacitors, coils and resistances; and wherein the aim is to eliminate the reflections caused by unadapted line sections which interfere with the correct operation of the network.

Finally, the present invention discloses an auto-installable device comprising the novel active microfilter of the present invention, which separates plain old telephone services from broadband services with VDSL2 access technology, and at the same time partially or completely suppresses the negative effect of transfer rate reduction introduced by the telephone network topologies (ring, star, bus) arranged in the user's local equipment within the performance of the VDSL2 standard. Said auto-installable device comprises a power supply circuit which can be selected from an AC/DC converter, a rechargeable battery, a cell and a combination of the preceding elements, the effects of which lead to:

■ An improvement in transfer rate enabling new broadband services which require high transfer rates, and as a result of this, more added value services.
■ A coverage extension of broadband services, broadening the base of potential clients.

These improvements are achieved by maintaining the auto-installable feature of the current passive microfilters, and therefore, the solution proposed by the present invention does not involve an increase in the cost of providing broadband services.

Background of the Invention

Several devices such as splitters or microfilters for splitting low frequency signal which corresponds with the services of plain old telephone network POTN, and high frequency signal which corresponds to broadband services with standards based on xDSL digital subscriber lines, are available on the market today. The second option, microfilters, also known as inline filters, is the most common solution used in user's local equipment because they can be installed directly by the end user. Splitters must be installed by the employees of the telephone services company, the installation of which is very expensive, therefore it is scarcely used.

The microfilters used today are passive devices made of coils, resistances and capacitors, and are arranged only in the telephone connectors where the telephone terminal is to be connected by the end user.

The microfilters described above have a load impedance causing the microfilters to behave like a transmission line with its end open for frequencies greater than 4 kHz (upper limit of the POTN spectrum).

Therefore, whether the transmission line section has an open end or a microfilter, said transmission line section arranged in the part of the user's local equipment behaves, as seen from the equipment of the service-providing main telephone office, like a resistance in parallel without adapting to frequencies greater than 4 kHz if the product of its length times its ß phase (radians/km)) is an integer and an odd number of times JI radians, causing the subsequent drop in transmission speed.

The impedance adaptation problem described above is not very significant in ADSL and ADSL2+ technologies that work at maximum frequencies of 1.104 MHz and 2.208 MHz, respectively. At these frequencies it is difficult for the product of length times phase (ß(radians/km)) to be an integer and odd number of times JI radians. In contrast, this problem becomes very significant as the frequency gradually increases, such as for example, for frequencies at which the VDSL2 technology works which can reach 30 MHz.

Solutions to the technical problem of adapting the impedances introduced by the line sections distributed throughout the different enclosures made up by the user or buildings, which are connected to the main xDSL service distributing telephone network by means of an active microfilter arranged in an auto-installable device forming any network typology, solved by the present invention are not known.

The closest solutions found relating to the technical problem solved by the present invention are:

■ Patent US6829336 81, entitled "System and Method for Active Filtering in a Telecommunications Network", describes an active microfilter powered by a network power source. Although this patent discloses an improvement of the low pass filters by means of a low pass active filter included in the microfilter, this patent does not disclose nor suggest the use of active microfilters for impedance adaptation.
■ Patent US2009141183 A1, entitled "Active Splitter Device and Method Using Diplexed Front End", discloses a solution for separating radio frequency signals transmitted from those received in communications systems without referring to xDSL splitters.

■ Patent US2008118058 A1, entitled "Splitter with Active Transient Suppression Circuit", discloses an active splitter and not a microfilter, the function of which is to filter the transients in telephone lines. This patent does not disclose nor suggest the use of active microfilters for impedance adaptation.

■ Patent W09940716 A2, entitled "Active Splitter", discloses an active splitter and not a microfilter, used to improve low pass filters.

■ Patent EP1901540 A1, entitled "ADSL Splitter", discloses a passive splitter and not an active microfilter.

■ Patent EP1783996 A1, entitled "Advanced ADSL Splitter", discloses a passive splitter instead of an active microfilter such as that of the present invention.

■ Patent US6868117 B1, entitled "Splitter and microfilter dongle for a single RJ11 DSL/analog combo modem", discloses a device capable of switching received signals electrically and working interchangeably on a splitter such as in the environment of a microfilter.

Description of the Invention

To solve the drawbacks indicated above, this invention consists of an active microfilter made up of an active part basically comprising a sign inverter circuit, and of a passive part forming the characteristic parameters of the line section to be adapted, such that it mitigates or eliminates reflections due to said unadapted line sections when accessing broadband with VDSL2 technology (Very-High-Bit-Rate Digital Subscriber Line 2). The present invention is completed with a power supply circuit supplying power of the active components.

The user's local equipment tends to be divided into N enclosures, each of them having line sections or branches connected to the main telephone line. The configurations of said line sections or branches can be ring, star or bus configurations. Although the main line will be connected to the xDSL modem arranged in any one of the enclosures of the user's local equipment, other different configurations such as an open-circuit branch to which no device is connected, a branch to which a telephone terminal is connected by means of a passive filter, etc., can be obtained in the rest.

The present invention comprises an active microfilter connected to all the line sections or branches of the user's local equipment to adapt the impedance in parallel introduced by the line section or branch. The main telephone line is thus connected to the active microfilter of impedance $Z_L$ and reflection coefficient $p_L$, by the line section or branch at an intermediate point of the main telephone line, said line section or branch being characterised by length L, characteristic impedance $Z_0$ and a propagation function $\gamma = \alpha + j\beta$; where $\alpha$ is the attenuation of the line and $\beta$ is the phase function of the line. The line section or branch together with the load impedance $Z_L$ introduce a joint impedance in parallel $Z_V$ at the attachment point for attachment with the main telephone line. Said impedance $Z_V$ generates a reflection coefficient $p_V$, such that:

$$\rho_L = \frac{Z_L - Z_0}{Z_L + Z_0}$$

$$\rho_V = \rho_L \cdot e^{-2\gamma L} = \rho_L \cdot e^{-2(\alpha + j\beta)L}$$

$$Z_V = Z_0 \frac{1 + \rho_V}{1 - \rho_V}$$

If the line section or branch has an open circuit termination, which is what occurs in telephone connectors distributed throughout the different enclosures of the user's local equipment, the load impedance $Z_L$ is infinite, and the reflection coefficient at the attachment point will be $\rho_V = e^{-2\gamma L}$. The line section or branch therefore loads the main telephone line with an unwanted problematic frequency-dependent impedance. In a user local telephone network with a star topology, all the branches of said local network load the main network with countless impedance across the entire frequency range. This means that each branch introduces a reflection coefficient $\rho_V$ equal to 1 across the entire frequency range. By applying this condition, the load impedance which each line section or branch has over the main telephone line with a star typology is obtained:

If:

$$p_v = 1$$

then:

$$1 = p_L \cdot e^{-2\gamma L} \Rightarrow p_L = e^{2\gamma L} \Rightarrow$$

$$\Rightarrow Z_L = Z_0 \cdot \frac{(1+p_L)}{(1-p_L)} = Z_0 \cdot \frac{(1+e^{2\gamma L})}{(1-e^{2\gamma L})} = -\frac{Z_0}{\tanh(\gamma \cdot L)}$$

This last expression represents the load impedance $Z_L$ required by each line section or branch so that said line section or branch behaves like an open circuit across the entire frequency range at the connection point with the main telephone line. Given that the real lines have losses, the linear attenuation coefficient $\alpha$ must be added to the expression calculated above. Said linear attenuation coefficient $\alpha$ requires a load impedance with negative resistance for adapting the losses in the transmission line section.

To enable obtaining the negative resistance and therefore adapting the load impedance, the present invention has a sign inverter circuit made up of active components the main function on which is to invert the sign of the impedance Z to be adapted and the sign of which is therefore inverted. In a particular embodiment of the invention, said sign inverter circuit is basically made up of an operational amplifier the output of which is connected to its non-inverter input by means of impedance Z the sign of which is inverted. The output of the operational amplifier is also connected to the potential reference line by means of a resistance $R_1$ connected in series with a resistance $R_2$, there being a connection between the inverter input and the attachment point of these resistances $R_1$ and $R_2$, such that the impedance of the sign inverter circuit is $Z_L$ and its value is $Z_L = -Z(R_2/R_1)$.

In said particular embodiment said sign inverter circuit therefore inverts the sign of the impedance Z, with a scale factor equal to $R_2/R_1$ (ratio between the nominal values of the resistances $R_1$ and $R_2$), assuming that the differential gain A of the operational amplifier approaches infinity, although, in practice gains equal to or greater than 10 are sufficient. If the above condition is not fulfilled, the requirement to invert at least the sign of the impedance is the following:

$$A > 1 + \frac{R_2}{R_1}$$

In this case, the load impedance $Z_L$ is:

$$Z_L = -Z \cdot \frac{\left(1 + A \cdot \dfrac{R_2}{(R_1 + R_2)}\right)}{\left(A \cdot \dfrac{R_2}{(R_1 + R_2)} - 1\right)}$$

Consequently, with said particular embodiment of the present invention it is always possible to invert the sign of the impedance.

Once the sign of the impedance is inverted, the value thereof is determined. As has been disclosed above, the absolute value of the load impedance required is $Z = Z_0/\tanh(\gamma L)$ whereas the sign inverter circuit will be that responsible for changing the sign of said value of the impedance Z. The value of the impedance Z mentioned above is a well known value since it coincides with the value of the impedance introduced by a line section or branch, the end of which is open forming an open circuit, said line section or branch having a length L, a characteristic impedance $Z_0$, and a propagation function $\gamma$. Therefore, a metal couple section (metal cable, preferably copper, with wires therein) with the same length (L) and characteristics ($Z_0$ and $\gamma$) as the branch the effects of which are to be suppressed will introduce an impedance of value $z = Z_0/\tanh(\gamma \cdot L)$, with a reflection coefficient $\rho = e^{-2\gamma L}$.

Given that it is difficult to know the length of the metal couple section which has to be used to achieve value Z in practice, the present invention incorporates a passive part together with the active part.

In a particular embodiment of the present invention, the passive part comprises a four-port RLGC passive circuit which, by means of passive components such as coils, resistances and capacitors, forms the characteristics of the metal couple section, i.e., its characteristic impedance $Z_0$, its length L and its propagation function $\gamma$. Such circuits are made up of a resistance and a coil in series, and of a resistance and a capacitor in parallel with the active part, defining the parameters of resistance in series R, inductance in series L, conductance in parallel G and capacitance in parallel C, respectively.

Alternatively, the particular embodiment of the present invention uses, for line section to be adapted longer than L, as many four-port RLGC in cascade as the number of times the length L characteristic of the metal couple section.

To connect the active microfilter of the present invention to the telephone terminals, the active part of the active filter of the present invention includes a passive LC filter connected to the input of the sign change circuit by means of two capacitors arranged in each input of the sign change circuit. The passive LC filter comprises two coils in series, one per input, a capacitor in parallel between both inputs. The telephone terminal can thus be remotely supplied by the main telephone office. The passive part formed by the four-port RLGC is connected to the active part by the output of the operational amplifier and the non-inverter input thereof.

To supply the active components of the active microfilter of the present invention, a power supply circuit selected from a direct-alternating current AC/DC converter, a power supply element and a combination of both. The power supply element is selected from a rechargeable battery, a cell and combinations thereof. Said rechargeable battery is susceptible to being recharged by the direct-alternating current AC/DC converter or by another external charger. The combination of the alternating-direct current AC/DC converter with the battery rechargeable by the AC/DC converter is especially interesting, since it assures the operation of the active microfilter in the absence of alternating current due, for example, to a power cut in the electric network.

The proposed solution works in the frequency ranges of the very-high-bit-rate digital subscriber line 2 VDSL2 protocol which are between 23.76875 kHz to 30 MHz. Therefore, the solution proposed by the present invention is also valid for other types of technologies based on xDSL digital subscriber line, such as asymmetric digital subscriber line ADSL (ITU-TG.992.1, 23.76875 kHz - 1.104 MHz) and ADSL2+ (ITU-T G.992.5, 23.76875 kHz 2.208 MHz).

Additionally, the solution proposed by the present invention is valid for all type of telephone network topologies in user's local equipment such as star topology, ring topology or bus topology, due to the fact that it suppresses the impedance in parallel introduced by each line section or branch.

In the particular embodiment mentioned above, the RLGC sections must be formed according to the technical features (characteristic impedance, length, propagation function) of the metal couple used in the telephone network of the user's local equipment which can vary depending on the country. In the case of Spain, the characteristics of the metal couple are specified by the ICT (Common Telecommunications Infrastructures) regulation in force in Spain.

Brief Description of the Drawings

Figure 1 shows a simplified connection diagram between the main telephone office providing the xDSL service, and the user's local equipment where two different types of configurations can be observed.

Figure 2 shows the distribution of the telephone line within the user's local equipment which is divided into N rooms.

Figure 3 shows the main telephone line which starts from the main telephone office and is connected to the xDSL modem of the user's local equipment. A load impedance $Z_L$ is connected at an intermediate point of said main telephone line by means of a branch or a line section of a metal couple.

Figure 4 shows a circuit of active components such as that used by the present invention to invert the sign of the impedance Z to be adapted.

Figure 5 shows the main telephone line which starts from the main telephone office and is connected to the xDSL modem of the user's local equipment. A load impedance $Z_L$ is connected at an intermediate point of said main telephone line by means of a branch or a line section of the metal couple. A line section or branch is connected to said impedance $Z_L$.

Figure 6 shows the active microfilter connected to the line section, the active part and its components, and the passive part and its components depending on the length L of the section.

Figure 7 shows the auto-installable device comprising the active microfilter of the present invention, the connection of said device to a telephone terminal and to the conventional power source of the electric network, where the power supply circuit is made up of a direct-alternating current AC/DC converter and a battery rechargeable by said direct-alternating current AC/DC converter.

Figure 8 shows the auto-installable device comprising the active microfilter of the present invention, the connection of said device to a telephone terminal and a power supply element.

Description of an Embodiment of the Invention

The present invention is additionally illustrated below by means of the following example which does not intend to limit the scope thereof and it further refers to the numbering used in the drawings.

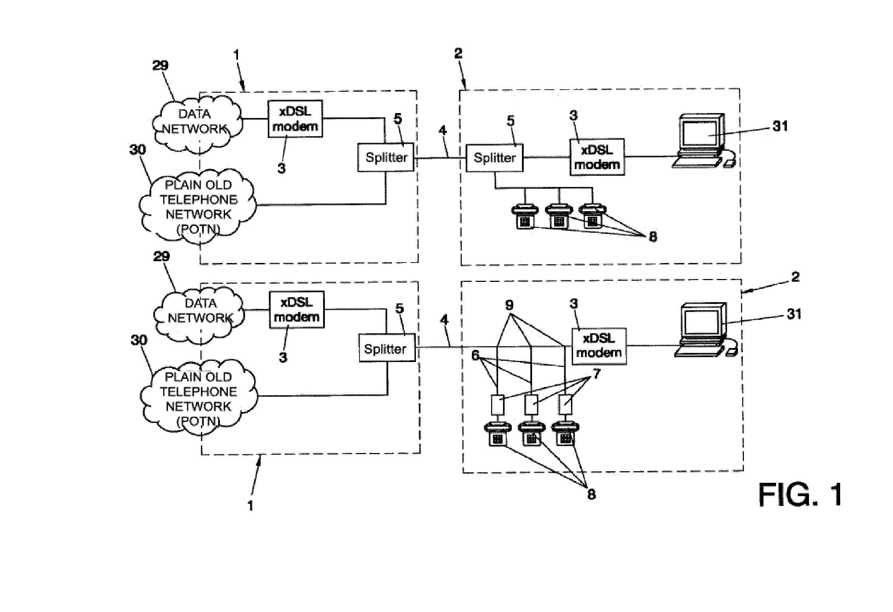

Figure 1 shows a simplified connection diagram between the main telephone office (1) and the user's local equipment (2) where two different types of configurations can be observed. The main telephone office (1) provides both the xDSL service originating from the data network (29) and plain old telephone services (30) which, by means of xDSL modem (3) and splitter (5) located in the main telephone office, allow transmitting both services through a single main telephone line (4). In the first configuration, a splitter (5) is located at the start of the user's local equipment (2), the xDSL modem (3) and the telephone terminals (8) being connected to same. A computer (31) is also connected to the xDSL modem (3). In the second configuration, the splitter (5) of the first configuration is replaced with microfilters (7) connected to the telephone terminals (8). As can be seen in Figure 1, there are as many microfilters (7) as telephone terminals (8).

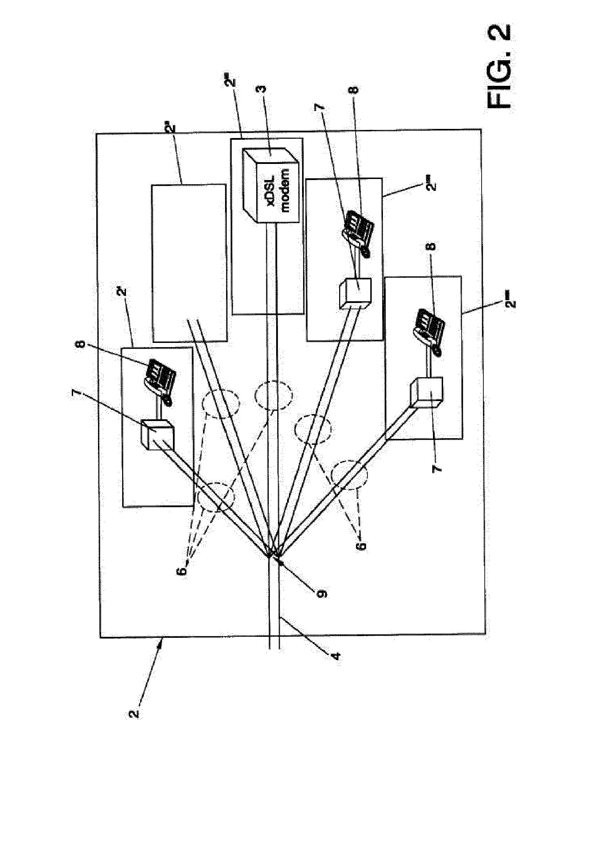

Figure 2 shows a distribution of a telephone network with a star topology within the user's local equipment (2), which is divided into N enclosures. In said distribution, the main telephone line (4) which is connected to the xDSL modem (3) arranged in enclosure 3 (2'''') can be distinguished. In enclosures 1 (2'), 4 (2'''') and N (2''''') of the distribution shown in Figure 2 respective telephone terminals (8) are arranged connected to the main telephone line (4) at the point (9), through the branch (6) and the microfilter (7). In enclosure 2 there is a branch (6) the end of which is not connected to any equipment, i.e., it forms an open circuit.

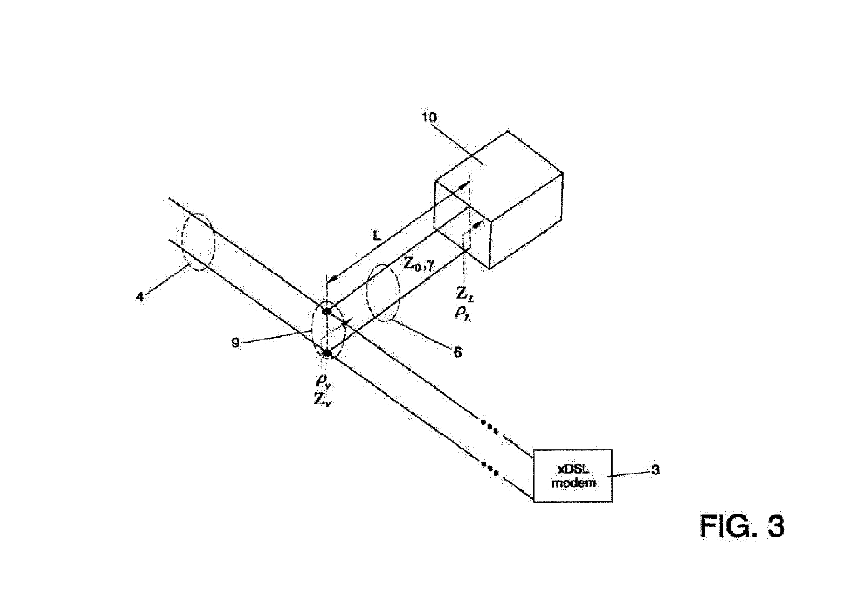

Figure 3 shows the main telephone line (4) which starts from the main telephone office (1) and is connected to the xDSL modem (3) of the user's local equipment (2). A load impedance $Z_L$ introducing a reflection coefficient $p_L$ is connected to said main telephone line (4) at an intermediate point (9) of said main telephone line by means of a metal couple line section or branch (6). Said line section or branch (6) is characterised by its characteristic parameters, the length L, characteristic impedance $Z_0$ and propagation function $\gamma = \alpha + j\beta$, where $\alpha$ is the attenuation of the line and ß is the phase function of the line. The line section or branch (6) together with the load impedance $Z_L$ introduce a joint impedance in parallel $Z_V$ at the attachment point (9) for attachment with the main telephone line (4). Said impedance $Z_V$ generates a reflection coefficient $\rho_V$, such that:

$$\rho_L = \frac{Z_L - Z_0}{Z_L + Z_0}$$

$$\rho_V = \rho_L \cdot e^{-2\gamma L} = \rho_L \cdot e^{-2(\alpha+j\beta)L}$$

$$Z_V = Z_0 \frac{(1+\rho_V)}{(1-\rho_V)}$$

If the line section or branch (6) has a open circuit termination, which is what occurs in the telephone connectors (24) distributed throughout the different enclosures of the user's local equipment (2), the load impedance $Z_L$ is infinite, and the reflection coefficient at the attachment point (9) is $\rho_V = e^{-2\gamma L}$. Therefore, branch (6) loads the main telephone line (4) with an unwanted problematic frequency-dependent impedance. In a user local telephone network with a star topology comprising all the branches (6), said branches (6) of said local network load the main network with an impedance infinite across the entire frequency range.

This means that each branch (6) introduces a reflection coefficient $\rho_V$ equal to 1 across the entire frequency range. By applying this condition, the load impedance which each branch (6) has over the main telephone line (4) with a star typology is obtained:

If:

$$\rho V = 1$$

then:

$$1 = p_L \cdot e^{-2\gamma L} \Rightarrow p_L = e^{2\gamma L} \Rightarrow$$

$$\Rightarrow Z_L = Z_0 \cdot \frac{(1+p_L)}{(1-p_L)} = Z_0 \cdot \frac{(1+e^{2\gamma L})}{(1-e^{2\gamma L})} = -\frac{Z_0}{\tanh(\gamma \cdot L)}$$

This last expression represents the load impedance $Z_L$ required by each branch (6) so that said branch behaves like an open circuit across the entire frequency range at the connection point (9) of the main telephone line (4). Given that the real lines have losses, linear attenuation coefficient $\alpha$ is added to the expression calculated above. Said linear attenuation coefficient $\alpha$ requires a load impedance with negative resistance for adapting the losses in the transmission line.

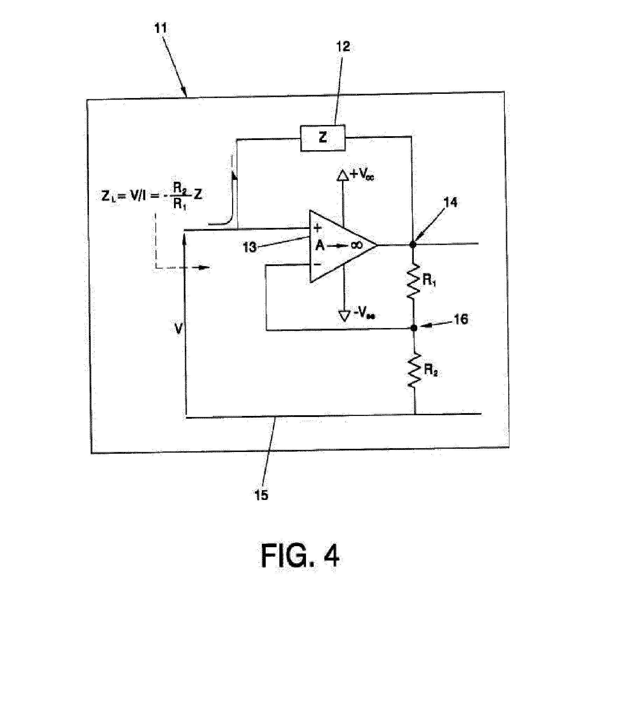

To enable obtaining negative impedance and therefore adapting the load impedance, the present invention comprises active microfilter for VDSL2 communication standard comprising an active part (19), a passive part (18) and a power supply circuit, where said active part (19) comprises a sign inverter circuit (11). Said active microfilter eliminating the reflections of unadapted line sections (6), the characteristic parameters of which are its impedance $Z_0$, its length L and its propagation function $\gamma$, and which line sections are adapted when connected at a point (9) to the main telephone line (1). Figure 4 shows a circuit of active components such as that used by the present invention to invert the sign of an impedance Z (12). Said circuit is a sign inverter circuit which is basically made up of an operational amplifier (13) the output of which is connected to its non-inverter input (+) by means of the impedance Z (12) the sign of which is inverted. The output of the operational amplifier is also connected to the potential reference line (15) by means of a resistance

$R_1$ connected in series with a resistance $R_2$, there being a connection between the inverter input (-) and the attachment point (16) of the resistances $R_1$ and $R_2$, such that the impedance of the sign inverter circuit (11) is $Z_L$ the value of which is $Z_L = -Z(R_2/R_1)$.

Therefore, a circuit such as that of Figure 4 inverts the sign of the impedance Z (12), with a scale factor equal to $R_2/R_1$ (ratio between the nominal values of the resistances $R_1$ and $R_2$), assuming that the differential gain A of the operational amplifier (13) approaches infinity, although, in practice gains equal to or greater than 10 are sufficient. If the above condition is not fulfilled, the requirement for the values of the resistances $R_1$ and $R_2$ and for inverting at least the sign of the impedance is the following:

$$A > 1 + \frac{R_2}{R_1}$$

In this case, the load impedance $Z_L$ is:

$$Z_L = -Z \cdot \frac{\left(1 + A \cdot \frac{R_2}{(R_1 + R_2)}\right)}{\left(A \cdot \frac{R_2}{(R_1 + R_2)} - 1\right)}$$

Consequently, with the preferred embodiment of the present invention it is always possible to invert the sign of the impedance. Once the sign of the impedance is inverted, the value thereof is determined.

As has been disclosed above, the absolute value of the load impedance Z (12) required is $Z = Z_0 / \tanh(\gamma \cdot L)$ whereas the circuit of the active part (19) will be responsible for changing the sign of said value Z. The value of the impedance Z (12) mentioned above is a well known value since it coincides with the value of the impedance introduced by a line section the end of which is open forming an open circuit, said line section having a length L, a characteristic impedance $Z_0$, and a propagation function $\gamma$, as shown in Figure 3.

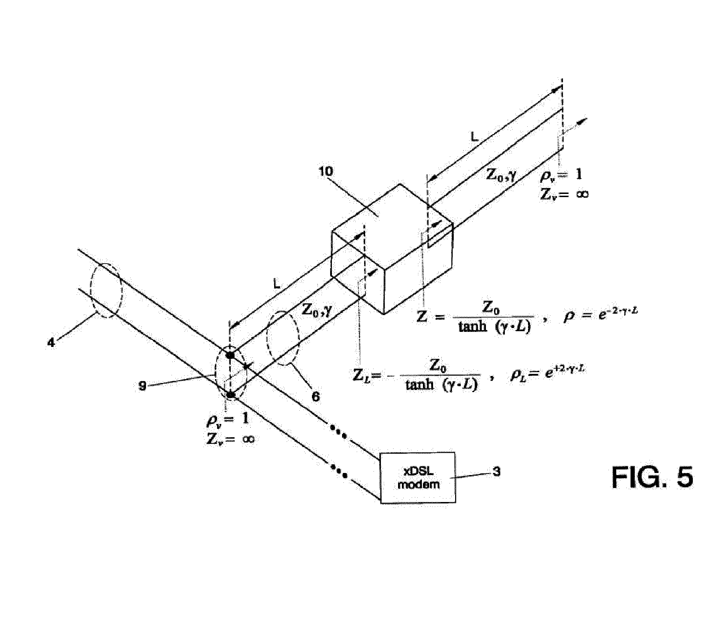

Therefore, the impedance Z (12) shown in Figure 4 can be obtained using a metal couple section (metal cable, preferably of copper, with wires therein) with the same length and characteristics ($Z_0$ and $\gamma$) as the branch (6) the effects of which are be suppressed as shown in Figure 5. Said metal couple section thus introduces an impedance $Z_0 = Z_0 / \tanh(\gamma \cdot L)$, with a reflection coefficient $\rho = e^{-2\gamma L}$.

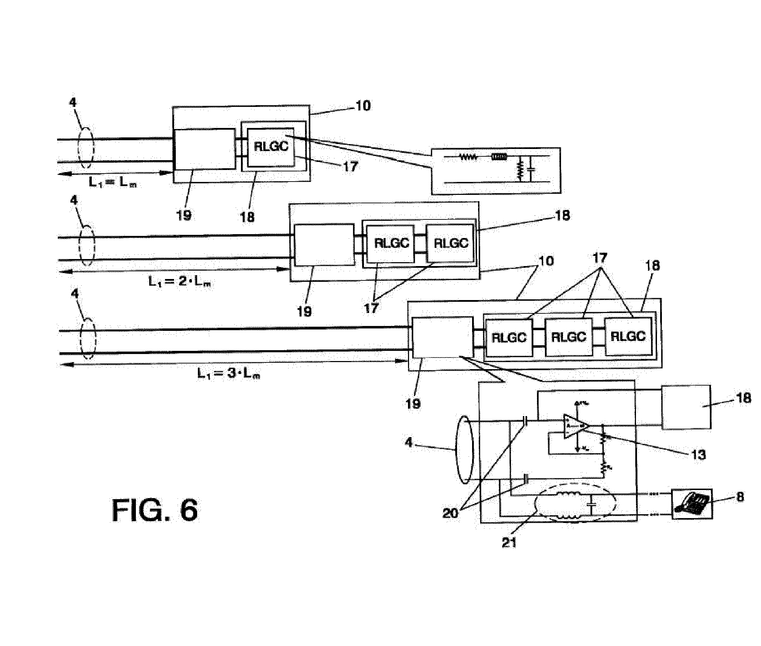

Given that it is difficult to know the length of the metal couple section which has to be used to achieve value Z (12) in practice, the present invention incorporates, together with the active part (19), a passive part (18) formed by at least one four-port RLGC (17) such as that shown in Figure 6 which by means of passive components such as coils, resistances and capacitors, forms the characteristics of the metal couple section, i.e., its characteristic impedance $Z_0$, its length L and its propagation function $\gamma$. Such circuits are made up of a resistance and a coil in series, and of a resistance and a capacitor in parallel with the active part, defining the parameters of resistance in series R, inductance in series L, conductance in parallel G and capacitance in parallel C, respectively.

Additionally, Figure 6 shows that for adapting line sections or branches of lengths greater than L, the present invention uses as many four-port RLGC (17) in cascade as the number of times the length L characteristic of the metal couple section.

More additionally, Figure 6 shows how the active part (19) of the active filter (10) of the present invention is connected to the passive part (18) and to the telephone terminal (8). The active part (19) of the active microfilter (10) of the present invention includes a passive LC filter (21) at the input of the sign inverter circuit (11) by means of two capacitors (20) arranged in each input of the sign inverter circuit (11). The passive LC filter (21) comprises two coils in series, one per input, a capacitor in parallel between both inputs. The telephone terminal (8) is thus remotely supplied by the main telephone office (1). The passive part (18) formed by at least one four-port RLGC is connected to the active part (19) by the output of the operational amplifier (14) and the non-inverter input (+) thereof.

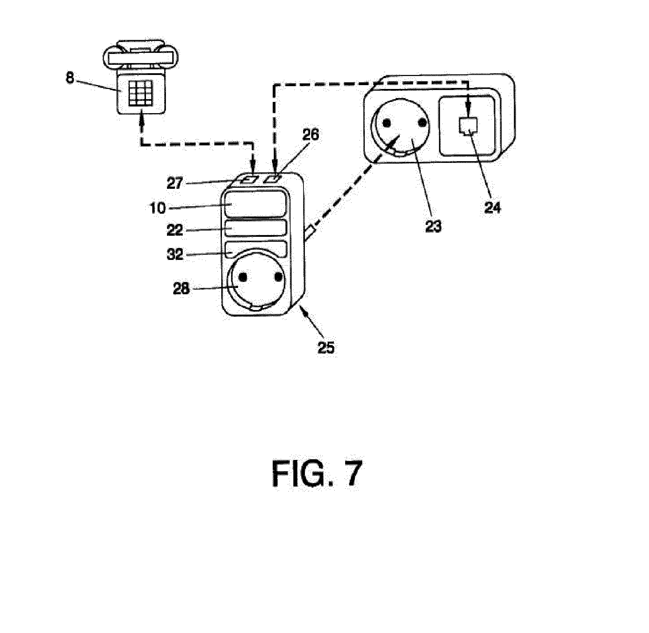

Figure 7 shows an auto-installable device comprising the active microfilter (10) of the present invention as well as a power supply circuit. With the technology current and, taking into account that the DC supply current relates directly to the product of the gain times the bandwidth, is not possible to power the active components of the active part of the active microfilter of the present invention by means of the power supply originating from the main telephone office (1), since with the telephone terminal hung-up, the supply current originating from said main telephone office is only 1 mA.

Said power supply circuit shown in Figure 7 comprises an AC/DC current converter (22) which is supplied by the conventional electric network socket (23) located in the user's local equipment (2) and provides the voltages and the supply currents necessary for the correct operation of the active microfilter. The power supply circuit of Figure 7 additionally comprises a rechargeable battery as the power supply element (32), which is recharged by the AC/DC current converter, and which assures the operation of the active microfilter in the absence of current originating from the conventional electric network socket (23). The capacitors (20) shown in Figure 6 prevent interferences between the power supply circuit of the active microfilter (10) and the supply of the telephone terminal (8) originating from the main telephone office (1).

Likewise, the auto-installable device (25) shown in Figure 7 further comprises the aforementioned elements, an input connector (26) and another telephone line output connector (27) which allow connecting the telephone terminals (8) to the main telephone line (4), such as a source of alternating current (28) providing the same voltage and current characteristics as the conventional electric network socket (23).

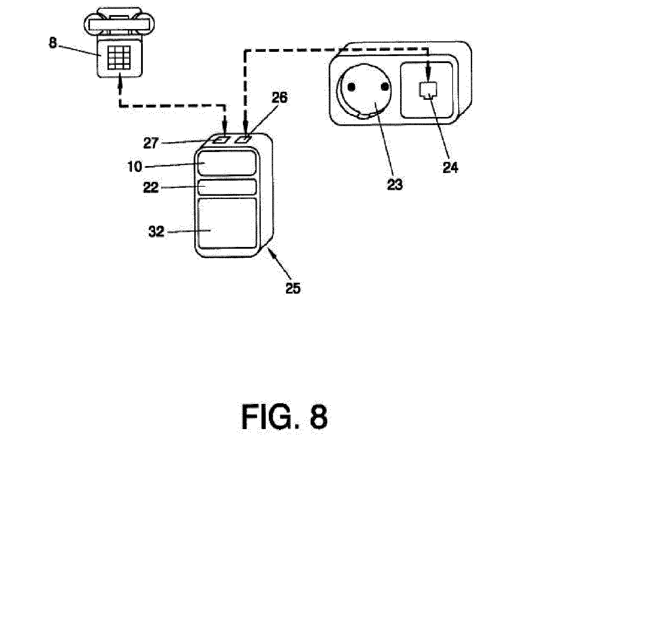

Figure 8 shows an auto-installable device (25) comprising the microfilter of the present invention and a power supply circuit formed by a power supply element selected from a rechargeable battery and a cell.

The auto-installable device (25) shown in Figure 8 also comprises the aforementioned elements, an input connector (26) and another telephone line output connector (27) which allow connecting the telephone terminals (8) to the main telephone line (4).

As a result of all these characteristics and those defined above the auto-installable device (25) which separates the plain old telephone services from broadband services with VDSL2 access technology and, at the same time, partially or completely suppresses the negative effect of transfer rate reduction introduced by the telephone network topologies (ring, star, bus) arranged in the user's equipment within the performance of the VDSL2 standard, is obtained.

**Claims**

1. An active microfilter for VDSL2 communication standard which eliminates the reflections of unadapted line sections (6), the characteristic parameters of which are impedance $Z_0$, length L and propagation function $\gamma$, and which line sections are adapted when connected at a point (9) to the main telephone line (1); **characterised in that** it comprises an active part (19) and a passive part (18), wherein said active part (19) comprises a sign inverter circuit (11).

2. The active microfilter for VDSL2 communication standard according to claim 1, **characterised in that** the active part comprises an operational amplifier (13) with a gain A, the output (14) of which is connected to its non-inverter input (+) by means of an impedance Z (12) the sign of which is inverted, said output (14) of the operational amplifier is also connected to a potential reference line (15) by means of a resistance $R_1$ in series with a resistance $R_2$, there further being a connection between the inverter input (-) of said operational amplifier (13) and the attachment point (16) of the resistances $R_1$ and $R_2$, such that the total impedance of the sign inverter circuit $Z_L$ depends on the values of $R_1$, $R_2$, A and Z, Z being the impedance of the line section to be adapted, the value of which is $Z=Z_0/\tanh(\gamma \cdot L)$.

3. The active microfilter for VDSL2 communication standard according to claim 2, **characterised in that** for absolute gain A values of at least 10, the total impedance of the sign inverter circuit $Z_L$ is:

$$Z_L = -Z(R_2/R_1)$$

4. The active microfilter for VDSL2 communication standard according to claim 2, **characterised in that** for absolute gain A values of less than 10, the values of resistances $R_1$ and $R_2$ meet the following relation:

$$A > 1 + \frac{R_2}{R_1}$$

and the total impedance of the sign inverter circuit (11) is:

$$Z_L = -Z \cdot \frac{\left(1 + A \cdot \dfrac{R_2}{(R_1 + R_2)}\right)}{\left(A \cdot \dfrac{R_2}{(R_1 + R_2)} - 1\right)}$$

5. The active microfilter for VDSL2 communication standard according to claim 3 or 4, **characterised in that** the passive part (18) comprises at least one four-port RLGC (17) comprising a resistance and a coil in series, and a resistance and a capacitor in parallel with the active part (19), which form the characteristic parameters of the line section to be adapted: characteristic impedance $Z_0$, length L and propagation function $\square$, obtaining the value of the impedance Z (12) of the line section (6) to be adapted.

6. The active microfilter for VDSL2 communication standard according to claim 5, **characterised in that** the passive part (18) comprises as many four-port RLGC (17) as the line section (6) to be adapted comprises multiples of length L.

7. The active microfilter for VDSL2 communication standard according to claim 3 or 4, **characterised in that** the active part (19) comprises two capacitors (20) arranged in series with the sign inverter circuit, one per input of said sign inverter circuit (11) which eliminate interferences between the supply originating from the main telephone office (1) of the telephone terminals (8) and the supply of the active microfilter (10).

8. The active microfilter for VDSL2 communication standard according to claim 7, **characterised in that** the active part comprises a passive LC filter (21) connected to the capacitors (20), made up of two coils in series with the capacitors (20), and a capacitor in parallel, allowing the remote supply of a telephone terminal (8) from a main telephone office (1).

9. An auto-installable device for VDSL2 standard, **characterised in that** it comprises an active microfilter for VDSL2 communication standard which eliminates the reflections of unadapted line sections (6), the characteristic parameters of which are impedance $Z_0$, length L and propagation function $\square$, and which line sections are adapted when connected at a point (9) to the main telephone line (1); wherein said active microfilter (10) comprises an active part (19) and a passive part (18), and wherein said active part (19) comprises a sign inverter circuit (11).

10. The auto-installable device for VDSL2 communication standard according to claim 9, **characterised in that** it comprises a power supply circuit, an input connector (26) and another telephone line output connector (27) which allow connecting telephone terminals (8) to the main telephone line (4) by means of an output connector (24) arranged in user's local equipment (2).

11. The auto-installable device for VDSL2 communication standard according to claim 9, **characterised in that** the power supply circuit comprises an option selected from the group consisting of a power supply element (32), an alternating-direct current AC/DC converter which is supplied from a conventional electric network socket (23), and a combination of both; wherein the power supply element is selected from a cell and a battery rechargeable at least by the AC/DC converter.

12. The auto-installable device for VDSL2 communication standard according to claim 10, **characterised in that** it comprises a source of alternating current (28) having the same characteristics as the conventional electric network socket (23) from which said auto-installable device (25) is supplied when the power supply circuit is made up of the alternating-direct current converter.

13. The auto-installable device for VDSL2 communication standard according to claim 9, **characterised in that** it is connected to all the line sections (6) of the user's local equipment (2) except the one which connects with an xDSL modem (3) for adapting all the impedances introduced by all the line sections (6) of said user's local equipment (2).

FIG. 1

FIG. 2

FIG. 3

$$Z_L = V/I = -\frac{R_2}{R_1} Z$$

FIG. 4

FIG. 5

FIG. 6

FIG. 7

FIG. 8

**REFERENCES CITED IN THE DESCRIPTION**

**Patent documents cited in the description**

- US 682933681 B
- US 2009141183 A1
- US 2008118058 A1
- WO 9940716 A2
- EP 1901540 A1
- EP 1783996 A1
- US 6868117 B1